# EUROPEAN PATENT APPLICATION

(11) **EP 4 491 883 A1**
(43) Date of publication of application: **15.01.2025**
(21) Application number: 24184055.2
(22) Date of filing: 24.06.2024
(51) Int. Cl.: F04D 29/42, F04D 29/60

(54) **COOLING MODULE**

(30) Priority: 12.07.2023 JP 2023114653
(71) Applicant: Aisin Corporation, Aichi 448-8650 (JP)
(72) Inventor: ISHII, Masato, Kariya, 448-8650 (JP); YANO, Hideto, Kariya, 448-8650 (JP)
(74) Representative: Winter, Brandl - Partnerschaft mbB

(57) **Abstract**

A cooling module (100) includes: a pump (2) configured to pressure-feed a fluid (F); and a manifold (1) having an outer wall (1g) on which an attachment surface (1e) for the pump is provided and including a fluid flow path (L) therein through which the fluid pressure-fed by the pump flows. A discharge port (132) of the pump is provided inside the manifold.

## Description

### TECHNICAL FIELD

This disclosure relates to a cooling module.

### BACKGROUND DISCUSSION

A technique for avoiding complication of a cooling pipe through which a coolant for cooling a motor, a battery, and the like provided in a vehicle such as an electric automatic vehicle flows is disclosed (for example, see CN216545710U (Reference 1)). Reference 1 discloses a thermal management module runner structure in which a coolant flow path is provided in an integrated waterway board formed by combining a lower substrate and an upper substrate.

In the thermal management module runner structure disclosed in Reference 1, a discharge port of a pump protrudes outward from the integrated waterway board, and thus a limited space of the vehicle in which the thermal management module runner structure is disposed cannot be effectively used.

A need thus exists for a cooling module with which a space can be effectively used.

### SUMMARY

According to an aspect of this disclosure, a cooling module includes: a pump configured to pressure-feed a fluid; and a manifold having an outer wall on which an attachment surface for the pump is provided and including a fluid flow path therein through which the fluid pressure-fed by the pump flows. A discharge port of the pump is provided inside the manifold.

According to such a characteristic configuration, the discharge port of the pump is formed inside the manifold. That is, the discharge port of the pump does not protrude to the outside of the manifold, and therefore, the space can be effectively used.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a perspective view illustrating a configuration of a cooling module according to an embodiment;
FIG. 2 is an exploded perspective view of the cooling module illustrated in FIG. 1;
FIG. 3 is a view illustrating configurations of a pump and a vicinity thereof according to the embodiment; and
FIG. 4 is a cross-sectional view taken along a line IV-IV shown in FIG. 3.

### DETAILED DESCRIPTION

Hereinafter, embodiments of a cooling module according to this disclosure will be described with reference to the drawings. However, this disclosure is not limited to the following embodiments, and various modifications can be made without departing from the gist of this disclosure.

### Cooling Module

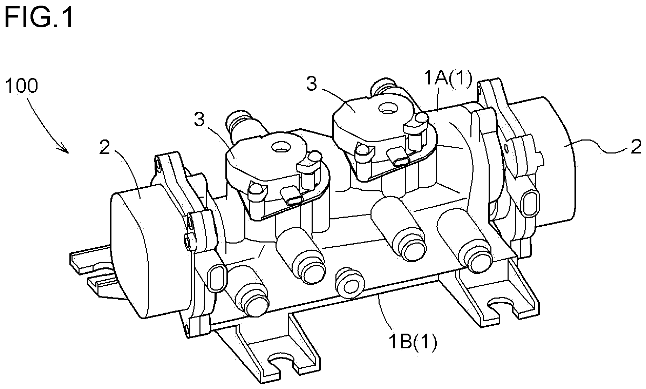

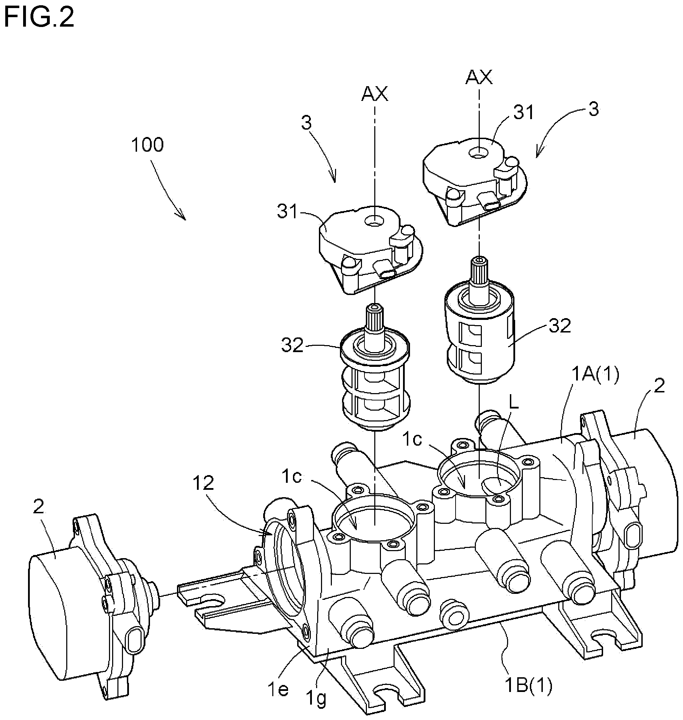

A cooling module 100 will be described with reference to FIGS. 1 and 2. FIG. 1 is a view illustrating a configuration of the cooling module 100. FIG. 2 is an exploded perspective view of the cooling module 100 illustrated in FIG. 1. The cooling module 100 is mounted on an electric vehicle that travels by electric power. Examples of the electric vehicle include a hybrid electric vehicle (HEV), a plug-in hybrid electric vehicle (PHEV), a battery electric vehicle (BEV), and a fuel cell electric vehicle (FCEV).

The cooling module 100 constitutes a part of a cooling system (not shown) that cools a cooling target device mounted on an electric vehicle, such as a vehicle driving device (for example, an inverter/motor) for driving a vehicle and a battery. The cooling system includes a radiator, a chiller, auxiliary devices such as pumps 2 and valves 3 illustrated in FIG. 1, and a fluid flow path L (see FIG. 2) through which a fluid F for cooling the cooling target device flows. The auxiliary devices and the cooling target device (inverter/motor, battery, etc.) are connected via the fluid flow path L. The fluid F is a cooling fluid such as a long life coolant (LLC). In this case, the fluid F is not limited to a cooling fluid such as a long life coolant (LLC), and may be a refrigerant such as an insulating oil, for example, a paraffin-based oil, a hydrofluorocarbon (HFC), and a hydrofluoroolefin (HFO).

As shown in FIGS. 1 and 2, the cooling module 100 includes a manifold 1, pumps 2, and valves 3. In the present embodiment, two pumps 2 and two valves 3 are provided, and the manifold 1, the two pumps 2, and the two valves 3 are integrated. The pumps 2 are electric water pumps and have substantially the same configuration except for positions where the pumps 2 are attached to the manifold 1. As shown in FIG. 2, the valve 3 is a rotary valve and includes an actuator 31 that generates power by being supplied with electric power, and a valve body 32 that rotates when receiving power from the actuator 31.

### Manifold

The manifold 1 has a box shape and includes the fluid flow path L therein as shown in FIGS. 2 to 4. The manifold 1 includes a first housing 1A and a second housing 1B that are made of a resin. The manifold 1 is formed by integrally joining the first housing 1A and the second housing 1B by welding or the like. The fluid flow path L is formed by a groove, a hole, or the like formed in at least one of the first housing 1A and the second housing 1B.

### Pump

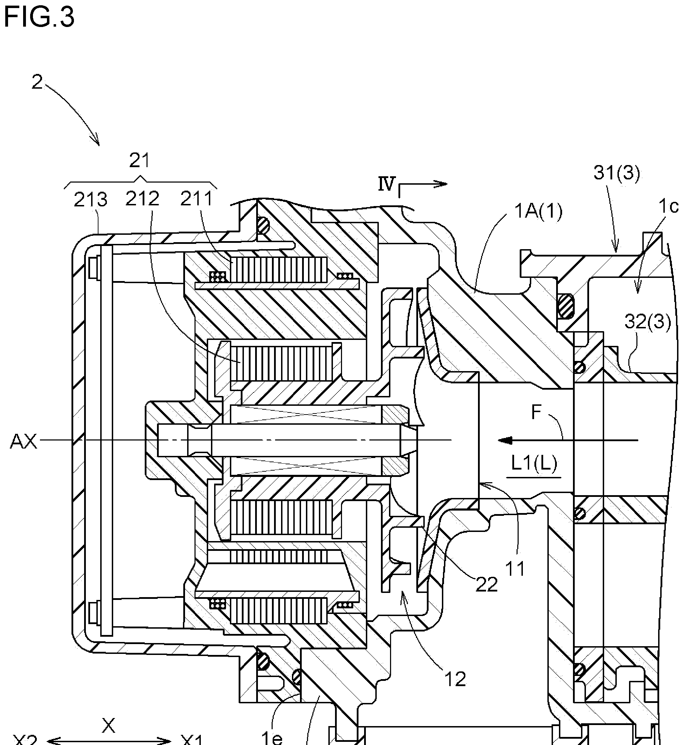

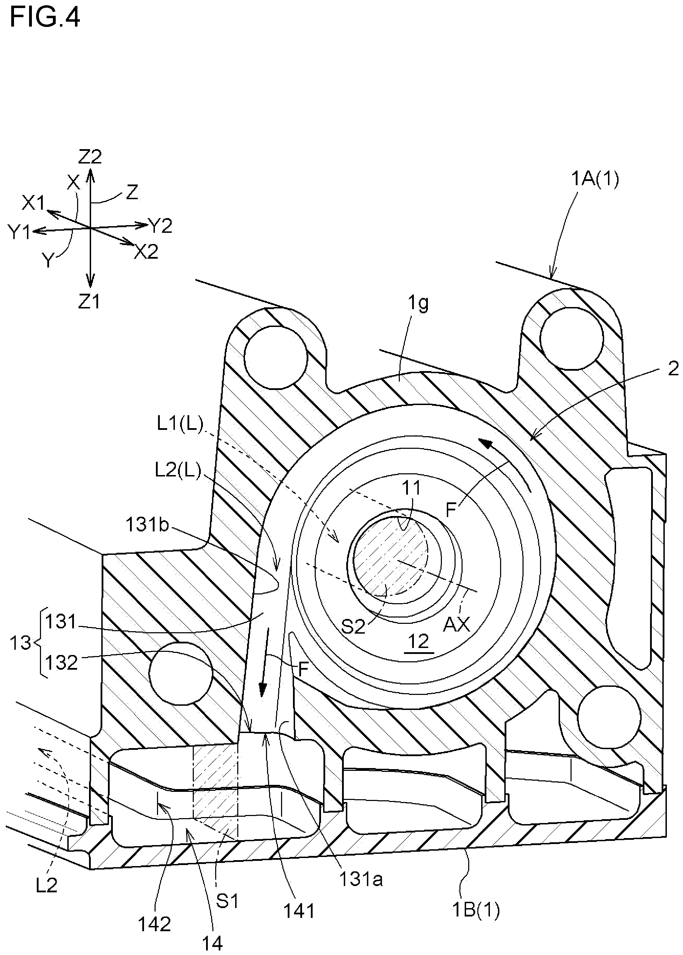

The pump 2 pressure-feeds the fluid F so that the fluid F flows in the fluid flow path L. Hereinafter, a portion of the fluid flow path L, which is upstream of the pump 2, is referred to as a "first flow path L1" (see FIG. 3), and a portion of the fluid flow path L, which is downstream of the pump 2, is referred to as a "second flow path L2" (see FIG. 4).

As shown in FIG. 3, the pump 2 includes an electric motor 21 that generates power by being supplied with electric power, and an impeller 22 that rotates by the power from the electric motor 21.

The electric motor 21 includes a stator 211 that generates a magnetic flux by being supplied with electric power, a rotor 212 that rotates about a rotation axis AX when the stator 211 generates the magnetic flux, and a motor cover 213 that accommodates the stator 211 and the rotor 212. Hereinafter, a direction along the rotation axis AX is referred to as an "X direction". In the X direction, a direction from the electric motor 21 toward the impeller 22 is referred to as an "X1 direction", and a direction opposite thereto is referred to as an "X2 direction".

The electric motor 21 (the stator 211, the rotor 212, and the motor cover 213) is attached, by a fastening member such as a bolt, to an attachment surface 1e (see FIG. 3) provided on an outer wall 1g of the manifold 1 in the X1 direction. The attachment surface 1e is a plane perpendicular to the X direction and is a part of the outer wall 1 g of the manifold 1. That is, only the electric motor 21 of the pump 2 is provided outside the manifold 1.

As shown in FIGS. 3 and 4, the manifold 1 also functions as a part of the pump 2. As described above, the two pumps 2 are attached to the manifold 1 in the present embodiment, and the configurations of portions of the manifold 1 to which the two pumps 2 are attached are substantially the same. Therefore, a configuration of one side of the manifold 1 (an end portion in the X2 direction) will be described below.

As illustrated in FIG. 4, the manifold 1 includes a suction port 11 (an inlet of the pump 2) that is a connection port with the first flow path L1, a vortex chamber 12 that communicates with the suction port 11, and a discharge portion 13 that communicates with the vortex chamber 12. The suction port 11, the vortex chamber 12, and the discharge portion 13 are provided (formed) in the X1 direction (inside the manifold 1) with respect to the attachment surface 1e.

The suction port 11 is circular when viewed in the X direction, and an axis of the suction port 11 is parallel to the X direction. As illustrated in FIG. 3, the suction port 11 faces, in the X direction, a portion (hereinafter, referred to as a "valve housing 1C") of the first housing 1A that accommodates the valve 3 (valve body 32). Accordingly, the pressure loss of the fluid F can be reduced. In addition, the configuration of the fluid flow path L (the first flow path L1) between the valve 3 and the suction port 11 can be avoided from being complicated.

As shown in FIG. 4, the vortex chamber 12 has a circular shape centered on the suction port 11 when viewed along the X direction, and increases in diameter toward the X2 direction. As shown in FIG. 3, the impeller 22 is rotatably disposed in the vortex chamber 12. In the present embodiment, the impeller 22 rotates counterclockwise as viewed along the X1 direction. Accordingly, the fluid F is sucked into the vortex chamber 12 from the first flow path L1 via the suction port 11. The fluid F flowing into the vortex chamber 12 swirls (swirls counterclockwise as viewed along the X1 direction) with the rotation of the impeller 22, and then flows to the discharge portion 13.

As shown in FIG. 4, the discharge portion 13 is provided downstream of the vortex chamber 12 in the flow direction of the fluid F (the rotation direction of the impeller 22). The discharge portion 13 includes a discharge passage 131 through which the fluid F flowing in from the vortex chamber 12 flows, and a discharge port 132 (discharge port of the pump 2) provided at a terminal end of the discharge passage 131. An axis of the discharge port 132 is perpendicular to the axis of the suction port 11. Hereinafter, a direction along the axis of the discharge port 132 is referred to as a "Z direction", and a direction perpendicular to the X direction and the Z direction is referred to as a "Y direction".

The discharge passage 131 extends along the Z direction and increases in diameter toward the discharge port 132 (at least the length in the Y direction increases toward a Z1 direction). That is, the discharge passage 131 is formed such that a flow path cross-sectional area (a cross-sectional area of the discharge passage 131 when cut along a direction perpendicular to the flow direction of a main flow of the fluid F) increases toward the discharge port 132. Specifically, a first outer edge 131a forming the discharge passage 131 extends along the Z direction, and a second outer edge 131b of the discharge portion 13 extends in a tangential direction of an outer circumference of the circular vortex chamber 12. The first outer edge 131a is an outer edge of the discharge passage 131 on a side close to the vortex chamber 12 when viewed along the X direction, and the second outer edge 131b is an outer edge of the discharge passage 131 on a side far from the vortex chamber 12 when viewed along the X direction.

The fluid F flowing from the vortex chamber 12 into the discharge portion 13 flows through the discharge passage 131, and then is discharged from the discharge port 132. Hereinafter, in the Z direction, a direction along a direction in which the fluid F (the main flow of the fluid F) is discharged from the discharge port 132 is referred to as the "Z1 direction", and a direction opposite thereto is referred to as a "Z2 direction".

### Flow Path Connection Chamber

The manifold 1 further includes a flow path connection chamber 14 into which the fluid F discharged from the discharge port 132 flows.

The flow path connection chamber 14 communicates with the discharge passage 131 (discharge port 132) and also communicates with the second flow path L2. That is, the flow path connection chamber 14 is provided between the discharge port 132 and the second flow path L2 (fluid flow path L).

In the present embodiment, the flow path connection chamber 14 has a substantially rectangular shape with the Y direction as a longitudinal direction when viewed along the X direction.

The flow path connection chamber 14 has an inflow port 141 communicating with the discharge passage 131 (discharge port 132) and an outflow port 142 communicating with the fluid flow path L (second flow path L2). The fluid F flowing into the flow path connection chamber 14 via the discharge port 132 and the inflow port 141 flows to the second flow path L2 via the outflow port 142.

The inflow port 141 and the outflow port 142 are provided apart from each other in the Y direction (in the present embodiment, the inflow port 141 and the outflow port 142 are provided at positions farthest from each other in the Y direction of the flow path connection chamber 14). A direction from the inflow port 141 toward the outflow port 142 in the Y direction is referred to as a "Y1 direction", and a direction opposite thereto is referred to as a "Y2 direction".

An axis of the inflow port 141 is parallel to the Z direction, and axes of the outflow port 142 and the second flow path L2 are parallel to the X direction. That is, the axis of the outflow port 142 is perpendicular to an axis direction of the inflow port 141 (discharge port 132) and is parallel to the axis of the suction port 11.

The flow path connection chamber 14 is provided as a buffer (spare space) for allowing the fluid F discharged from the pump 2 to smoothly flow to the second flow path L2, and has a sufficient volume so as not to affect the pressure loss of the fluid F. In the present embodiment, the flow path connection chamber 14 has a space (flow path cross-sectional area) through which the fluid F can flow and which is larger than the second flow path L2.

In the present embodiment, a flow path cross-sectional area (hereinafter, referred to as a "first flow path cross-sectional area S1") of the flow path connection chamber 14 is larger than a flow path cross-sectional area (hereinafter, referred to as a "second flow path cross-sectional area S2") of the suction port 11. The first flow path cross-sectional area S1 is an area of a cut surface obtained by cutting the flow path connection chamber 14 along the Z direction, and the second flow path cross-sectional area S2 is an area of the suction port 11 when viewed along the X direction.

As described above, according to the above-described configuration, the discharge portion 13 (the discharge port 132) is provided inside the manifold 1. That is, the discharge portion 13 does not protrude to the outside of the manifold 1. In other words, a projected area of the cooling module 100 along the Z direction decreases. Therefore, a size of the cooling module 100 can be reduced. Accordingly, the degree of freedom in designing a surrounding space of the cooling module 100 is improved, and a space of the vehicle in which the cooling module 100 is disposed can be effectively used (space efficiency is improved).

For example, in a configuration in which the discharge port of the pump protrudes to the outside of the manifold 1, the work of fastening hoses through which the fluid flows to the discharge port protruding outward is necessary. However, according to the present embodiment, the discharge portion 13 (discharge port 132) is provided inside the manifold 1, and the discharge port 132 communicates with the second flow path L2 via the flow path connection chamber 14. Therefore, the work of fastening the hoses to the discharge portion 13 is not necessary. As a result, the efficiency of the work of mounting the cooling module 100 on the vehicle (mounting workability) is improved.

### Overview of Above-described Embodiment

In the above-described embodiment, the following configurations are considered.
(1) A cooling module 100 includes: a pump 2 configured to pressure-feed a fluid F; and a manifold 1 having an outer wall 1g on which an attachment surface 1e for the pump 2 is provided and including a fluid flow path L therein through which the fluid F pressure-fed by the pump 2 flows. A discharge port 132 of the pump 2 is provided inside the manifold 1.

According to this configuration, the discharge port 132 of the pump 2 is provided inside the manifold 1. That is, the discharge port 132 of the pump 2 does not protrude to the outside of the manifold 1, and therefore, the size of the manifold 1 can be reduced. In addition, the complication of an external shape of the manifold 1 can be avoided. As a result, the space in which the manifold 1 is disposed can be effectively used.

(2) In the cooling module 100 according to (1), the manifold 1 preferably includes a flow path connection chamber 14 between the discharge port 132 and the fluid flow path L.

According to this configuration, the fluid F discharged from the pump 2 can smoothly flow.

(3) In the cooling module 100 according to (2), an area of a cross section obtained by cutting the flow path connection chamber 14 along an axis of the discharge port 132 is preferably larger than a flow path cross-sectional area of a suction port 11 through which the fluid F is sucked into the pump 2.

According to this configuration, the pressure loss of the fluid F can be reduced.

(4) In the cooling module 100 according to (3), it is preferable that the suction port 11 is further provided inside the manifold 1.

According to this configuration, the suction port 11 does not protrude to the outside of the manifold 1, and therefore, the size of the manifold 1 can be reduced. In addition, the complication of an external shape of the manifold 1 can be avoided. As a result, the space in which the manifold 1 is disposed can be effectively used.

### Other Embodiments

Next, other embodiments of the cooling module will be described.
(1) In the cooling module 100, the number of the pumps 2 integrated with the manifold 1 is not particularly limited. The number of the valves 3 integrated with the manifold 1 is not particularly limited. The configuration of the manifold 1 is appropriately changed in accordance with the number of the pumps 2 and the valves 3 to be integrated.
(2) The case where the impeller 22 rotates counterclockwise when viewed in the X1 direction is described in the above-described embodiment, and the rotation direction of the impeller 22 may be an opposite direction (clockwise when viewed in the X1 direction). In this case, the positions of the discharge portion 13 and the flow path connection chamber 14 are changed in accordance with the rotation direction of the impeller 22.
(3) The flow path connection chamber 14 is provided between the discharge port 132 and the second flow path L2 in the above-described embodiment, and the flow path connection chamber 14 can also be omitted.
(4) The case where the first flow path cross-sectional area S1 is larger than the second flow path cross-sectional area S2 is described in the above-described embodiment, and the first flow path cross-sectional area S1 may be equal to the second flow path cross-sectional area S2. The first flow path cross-sectional area S1 may be smaller than the second flow path cross-sectional area S2.
(5) The discharge passage 131 is formed such that the flow path cross-sectional area increases toward the discharge port 132 in the above-described embodiment, and the flow path cross-sectional area of the discharge passage 131 may be constant.
(6) The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

### Industrial Applicability

The technique according to this disclosure can be used for a cooling module.

## Claims

1. A cooling module (100) comprising:
a pump (2) configured to pressure-feed a fluid (F); and
a manifold (1) having an outer wall (1g) on which an attachment surface (1e) for the pump is provided and including a fluid flow path (L) therein through which the fluid pressure-fed by the pump flows, wherein
a discharge port (132) of the pump is provided inside the manifold.

2. The cooling module according to claim 1, wherein
the manifold includes a flow path connection chamber (14) between the discharge port and the fluid flow path.

3. The cooling module according to claim 2, wherein
an area of a cross section obtained by cutting the flow path connection chamber along an axis of the discharge port is larger than a flow path cross-sectional area of a suction port (11) through which the fluid is sucked into the pump.

4. The cooling module according to claim 3, wherein
the suction port is further provided inside the manifold.
